# EUROPÄISCHE PATENTSCHRIFT

(11) **EP 3 257 966 B1**
(45) Veröffentlichungstag und Bekanntmachung des Hinweises auf die Patenterteilung: **20.10.2021**
(21) Anmeldenummer: 17174217.4
(22) Anmeldetag: 02.06.2017
(51) Int. Cl.: C23C 16/04, C23C 16/40, C23C 14/04

(54) **VERFAHREN UND VORRICHTUNG ZUM BESCHICHTEN VON VERPACKUNGSBEHÄLTERN**
METHOD AND DEVICE FOR COATING PACKAGING CONTAINERS
PROCÉDÉ ET DISPOSITIF DESTINÉS AU REVÊTEMENT DE RÉCIPIENTS D'EMBALLAGE

(30) Priorität: 13.06.2016 DE 102016110800
(43) Veröffentlichungstag der Anmeldung: 20.12.2017
(60) Teilanmeldung: 20160879.1
(73) Patentinhaber: Waldorf Technik GmbH, 78234 Engen (DE); Cavonic GmbH, 78234 Engen (DE)
(72) Erfinder: CZIZEGG, Wolfgang, 78256 Steisslingen (DE)
(74) Vertreter: Patent- und Rechtsanwälte Behrmann Wagner PartG mbB

(56) Entgegenhaltungen:
- WO-A1-2015/067739
- DE-A1- 10 221 461
- US-A1- 2006 264 044

## Beschreibung

Die Erfindung betrifft ein Verfahren gemäß dem Oberbegriff des Anspruchs 1 zum Beschichten von, insbesondere durch Spitzgießen und/oder Blasformen und/oder Tiefziehen hergestellten, Verpackungsbehältern aus Kunststoff, jeweils umfassend mindestens eine Kavität zur Aufnahme eines Packgutes, insbesondere von Lebens-, Kosmetik- oder Arzneimitteln, sowie mindestens eine, vorzugsweise die Kavität randseitig umfangsgeschlossen umschließende, Siegelfläche zum späteren Verschließen der Kavität mit einer Folie durch Siegeln der Folie an der Siegelfläche des Verpackungsbehälters mit einer Barriereschicht (bevorzugt gegen Wasserdampf und/oder Sauerstoffdurchtritt), insbesondere einer Si-Oₓ-Schicht, im Vakuum, wobei mehrere Verpackungsbehältnisse auf einen Träger aufgesetzt werden und die auf dem, bevorzugt horizontal orientierten, Träger befindlichen Verpackungsbehältnisse gemeinsam in einer Vakuumbeschichtungskammer mit der Barriereschicht (im Vakuum) beschichtet werden. Bevorzugt werden die Verpackungsbehältnisse nach dem Beschichten von dem Träger entnommen. Grundsätzlich ist es möglich, die Verpackungsbehältnisse auf den bereits in der Beschichtungskammer befindlichen Träger aufzusetzen und nach der Beschichtung von diesem wieder zu entnehmen. Bevorzugt ist eine Ausführungsform des Verfahrens, bei dem die Verpackungsbehältnisse außerhalb der Beschichtungskammer auf den Träger aufgesetzt, der Träger mit den Verpackungsbehältnissen in die Beschichtungskammer überführt und nach dem Vakuum-Beschichten der Träger aus der Beschichtungskammer entnommen wird, um dann die Verpackungsbehältnisse von dem Träger zu entnehmen.

Ferner führt die Erfindung auf eine Verwendung einer zur Durchführung eines erfindungsgemäßen Verfahrens ausgebildeten Vorrichtung gemäß dem Oberbegriff des Anspruchs 5, umfassend eine Vakuumbeschichtungskammer (Vakuumbeschichtungsvorrichtung), die ausgebildet ist zum Beschichten von Kunststoff-Verpackungsbehältnissen in Vakuum, insbesondere ausgebildet ist zur Durchführung eines CVD-Verfahrens (chemical vapour deposition) eines PECVD-Verfahrens (plasma enhanced chemical vapour deposition) oder eines PVD-Verfahrens (physical vapour deposition). Besonders bevorzugt ist die Beschichtungskammer zur Durchführung eines ALD-Verfahrens (atomic layer deposition) ausgebildet. Ferner umfasst die Vorrichtung Handhabungsmittel, um Träger für die zu beschichtenden Verpackungsbehälter mit den Verpackungsbehältern zu beladen, bevorzugt vor dem Einsetzen der Träger in die Vakuumbeschichtungskammer.

Aus der WO 2009/030 425 A1 sind ein Verfahren und eine Vorrichtung zur Herstellung von Verpackungsteilen mit einer Barriereschicht mit guter Durchtrittssperrwirkung gegen Wasserdampf und Gase bekannt. Aufgrund der Vakuum-Barriereschicht werden zwar einerseits erhöhte Durchtrittssperrwirkungen erzielt, andererseits erschweren sie in der Praxis das Siegeln an Siegelflächen. So kommt es nur zu einem ungenügenden Halt mit Standart-Siegelmethoden, wenn beispielsweise eine Deckelfolie unmittelbar auf die Beschichtung gesiegelt wird und es werden somit entweder haftvermittelnde Überlackschichten benötigt oder die Verpackungsteile müssen mit Stülp-, Schnapp- oder Klappdeckeln verschlossen werden. Diese Lösungen machen jedoch das Endprodukt deutlich komplexer und sind somit mit weiteren Kosten verbunden.

In der EP 2 518 102 A2 ist ein verbessertes Verfahren zum Beschichten von Verpackungsbehältern beschrieben. Hier wird die Siegelfläche der auf einem Träger aufstehenden Verpackungsbehälter mithilfe von Maskierelementen verdeckt, die nach dem Beschichtungsvorgang vor dem Entnehmen der Verpackungsbehälter von dem Träger von den Verpackungsbehältern entfernt werden. Das bekannte Verfahren hat sich bewährt - es bestehen jedoch Bestrebungen zu einer weiteren Vereinfachung des Beschichtungsverfahrens, wobei weiterhin gewährleistet sein soll, dass die, insbesondere ringförmige, d. h. umfangsgeschlossene Siegelfläche des Verpackungsbehälters zumindest weitgehend von der Barriereschicht frei bleibt.

Aus der DE 10 2011 052 149 A1 ist es bekannt, eine in einem Behälterinneren angeordnete Siegelfläche, die sich in der Behälterhocherstreckung zwischen zwei SiOₓ-Barriereschichten befindet, während der SiOₓ-Beschichtung mit einer abnehmbaren Maske zu maskieren, um eine Beschichtung der Siegelfläche mit SiOₓ zu verhindern.

Aus der DE 102 21 461 A1 ist es bekannt, Kunststoffflaschen zu beschichten. Die zu beschichtenden Flaschen weisen keine Siegelflächen auf, da sie mit einem meist verschraubbaren Verschlussdeckel verschlossen werden.

Aus der DE 10 2006 053 366 A1 ist ein Verfahren und eine Vorrichtung zur plasmaunterstützten chemischen Dampfphasenabscheidung bekannt. Die Siegelflächen werden in der Druckschrift nicht behandelt.

Die US 2006/0264044 A1 offenbart einen durch ein Plasma-CVD-Verfahren gebildeten CVD-Film und ein Verfahren zu dessen Herstellung, bei dem der zu beschichtende Körper in einer Beschichtungskammer gehalten wird.

Die WO 2015/067739 A1 betrifft einen beschichteten Behälter, der zwei verschiedene Lagen einer Barriereschicht aufweist.

Ausgehend von dem vorgenannten Stand der Technik liegt der Erfindung daher die Aufgabe zugrunde, ein vereinfachtes Beschichtungsverfahren sowie eine vereinfachte Vorrichtung hierfür anzugeben, mit denen sichergestellt wird, dass die Siegelfläche der Verpackungsbehälter zumindest weitgehend frei bleibt von der Vakuum-Barriereschicht, insbesondere einer SiOₓ-Schicht, um somit bei einem späteren Siegelvorgang, bei dem eine Folie an die Siegelfläche thermisch gesiegelt wird, eine gute Haftung zwischen Siegelfolie und Verpackungsbehälter bzw. Siegelfläche zu erreichen.

Diese Aufgabe wird hinsichtlich des Verfahrens mit den Merkmalen des Anspruchs 1 gelöst.

Hinsichtlich der Verwendung der Vorrichtung wird die Aufgabe mit den Merkmalen des Anspruchs 5 gelöst.

Vorteilhafte Weiterbildung der Erfindung ist in den Unteransprüchen gegeben.

Zur Vermeidung von Wiederholungen sollen verfahrensgemäß offenbarte Merkmale auch als vorrichtungsgemäß offenbart gelten und beanspruchbar sein. Ebenso sollen vorrichtungsgemäß offenbarte Merkmale auch als verfahrensgemäß offenbart gelten und beanspruchbar sein.

Der Erfindung liegt der Gedanke zugrunde, die Siegelfläche der Kunststoff-Verpackungsbehälter in der Beschichtungskammer dadurch vor einer Beschichtung mit der Vakuum-Barriereschicht mit guter Durchtrittssperrwirkung, insbesondere gegen Wasserdampf und Gase, vorzugsweise gegen Sauerstoff, zu schützen, dass die Verpackungsbehälter derart auf den Träger, insbesondere in einer horizontalen Ebene nebeneinander aufgesetzt werden, dass die Siegelflächen der Kunststoff-Verpackungsbehälter dem Träger zugewandt sind bzw. werden. Mit anderen Worten wird die Funktion der in der EP 2 518 102 A2 beschriebenen Maskiermitteln von dem Träger übernommen, wozu die Verpackungsbehälter bevorzugt mit ihrer die Siegelfläche aufweisenden Oberseite nach unten auf den Träger aufgesetzt werden. Hierdurch kann auf von dem Träger separate Maskiermittel zur Auflage auf der zu schützenden Siegelfläche verzichtet werden, wodurch das Verfahren und die Vorrichtung wesentlich vereinfacht werden. Die Siegelfläche umgibt, insbesondere randseitig eine Kavitätenöffnung der Kavität zur Aufnahme des Packguts und ist weiter bevorzugt umfangsgeschlossen bzw. ringförmig ausgebildet, um somit bei einem späteren Verschluss- bzw. Siegelschritt die mit Packgut befüllte Kavität verschließen zu können, indem die (Deckel-)Folie an die Siegelfläche gesiegelt wird. Da die Siegelfläche bei dem erfindungsgemäßen Verfahren zumindest weitgehend frei von der Vakuum-Barriereschicht bleibt, insbesondere frei von einer ALD-Barriereschicht, einer CVD-Barriereschicht, einer PECVD-Barriereschicht und/oder einer PVD-Barriereschicht wird der Siegelvorgang nicht behindert und die Folie kann in unmittelbaren Kontakt zu dem Kunststoff des Verpackungsbehälters treten, an dem sie thermisch gesiegelt wird. Wie erwähnt erfolgt der Siegelvorgang bevorzugt thermisch. Unter einem thermischen Siegelvorgang wird dabei ein Siegelvorgang unter Wärmung der Siegelfläche und/oder der Siegelfolie, insbesondere mittels eines, beispielsweise widerstandsbeheizten Anpressstempels verstanden, wobei die Siegelfolie mittels des Stempels gegen die Siegelfläche gepresst wird. Zusätzlich oder alternativ kann vor einem in Kontaktbringen von Siegelfolie und Siegelfläche die Siegelfolie und/oder die Siegelfläche erwärmt werden, beispielsweise mit einer Kontaktheizung oder durch Bestrahlung mit entsprechenden Wärmestrahlern.

Als Material für die Verpackungsbehälter kommt insbesondere Polyethylen (PE), Polypropylen (PP), Cyclo-Olefin-Copolymere (COC), Cyclo-Olefin-Polymere (COP), Polyvinylchlorid (PVC), Polyethylenterephthalat (PET) oder Polyamid (PA) oder andere im Vakuum stabile Polymere in Betracht. Auch ist es denkbar, die Verpackungsbehälter aus kompostierbaren Polymeren auszubilden, wie diese beispielsweise in der EP 2 518 102 A2 offenbart sind.

Ganz besonders bevorzugt ist es, wenn die Verpackungsbehälter unmittelbar mit ihrer Siegelfläche auf den Träger aufliegen, um somit den Abstand zwischen Siegelfläche und Träger gegen null zu reduzieren. Für den Fall, dass ein (geringer) Abstand bzw. eine (geringe) Restspalte zwischen der Siegelfläche und dem Träger verbleibt, ist dieser bevorzugt so zu wählen, dass die Beschichtungssubstanzen, insbesondere ein Beschichtungsplasma nicht oder im Wesentlichen nicht in diesen Spalt eindringen, sodass in jedem Fall die Siegelfläche beim Beschichten des Verpackungsbehälters zumindest größten Teils frei von der Barriereschicht bleibt.

Wie eingangs bereits angedeutet ist es bevorzugt, wenn die Verpackungsbehälter, insbesondere mit ihrer Oberseite nach unten noch vor dem Einsetzen des Trägers in die Beschichtungskammer auf den Träger aufgesetzt werden und nach dem Beschichtungsvorgang, nach der Entnahme des Trägers aus der Beschichtungskammer von diesem entnommen werden. Alternativ ist es denkbar, die Verpackungsbehälter auf den bereits in der Beschichtungskammer befindlichen Träger aufzusetzen und/oder auf dem in der Beschichtungskammer befindlichen Träger zu entnehmen - diese Vorgehensweise würde jedoch eine entsprechend großvolumigere Beschichtungskammer erfordern, was im Hinblick auf eine Bauraum- und Kostenreduzierung nachteilig sein könnte.

Im Hinblick auf einen automatisierten Beladungsprozess der Träger mit den Kunststoff-Verpackungsbehältern ist erfindungsgemäß vorgesehen, dass die Verpackungsbehälter jeweils in einer Zentriervertiefung auf dem Träger aufstehen. Die Querschnittsfläche dieser Zentriervertiefungen ist dabei geringfügig größer als die axiale Projektionsfläche des Verpackungsbehälters, sodass dieser kopfüber auf dem Träger aufgesetzt werden kann und bei der Handhabung des Trägers, insbesondere zum Beladen der Beschichtungskammer und/oder zum Entladen der Beschichtungskammer seitlich durch die Vertiefungsumfangswand gehalten wird. Bevorzugt weist die Zentriervertiefung eine geringe Tiefe von weniger als 2 cm, noch weiter bevorzugt von weniger als 1 cm, ganz besonders bevorzugt von weniger als 5 mm auf, bezogen auf eine Oberseite bzw. Außenfläche des Trägers. Bevorzugt ist ein Radialabschnitt zwischen dem Vertiefungsumfang und dem Verpackungsbehälter aus einem Wertebereich zwischen 0,1 mm und 2 mm, vorzugsweise zwischen 0,15 mm und 0,5 mm gewählt.

Erfindungsgemäß ist vorgesehen, dass die Verpackungsbehälter (einfach) auf den Verpackungsbehälter aufzusetzen, sodass diese ausschließlich aufgrund ihres Eigengewichtes während der Beschichtung auf dem Träger aufsitzen. Eine solche Vorgehensweise hat sich insbesondere als vorteilhaft herausgestellt für im Spritzgussverfahren hergestellte Verpackungsbehälter, da im Spritzgussverfahren die Siegelfläche geometrisch exakt ausgestaltet werden kann, insbesondere formkonstruktiv bzw. parallel zu einer entsprechenden Gegenfläche des Trägers.

Alternativ ist es jenseits des Gegenstandes der Erfindung denkbar, die Verpackungsbehälter während der Beschichtung mithilfe von Niederhaltemitteln gegen die Träger kraftzubeaufschlagen, insbesondere in einem (Kontakt-)Bereich außerhalb der Siegelfläche. Bei den Niederhaltemitteln kann es sich im einfachsten Fall um (passive) Gewichtsmittel handelt, die die Verpackungsbehälter und einer Gewichtskraft beaufschlagen. Alternativ ist es denkbar aktive Niederhaltermittel vorzusehen, die die Niederhaltekraft, bevorzugt außerhalb der Siegelfläche, mithilfe eines Aktors, beispielsweise eines pneumatischen, hydraulischen oder elektromotorischen Antriebs erzeugen. Unabhängig von der konkreten Ausgestaltung der Niederhaltemittel ist es bevorzugt, wenn diese auf den Verpackungsbehälter druckbeaufschlagen und zwar aus einer vom Träger abgewandten Seite der Verpackungsbehälter her. Die Verfahrensvariante mit Niederhaltemitteln ist insbesondere dann vorteilhaft, wenn Verpackungsbehälter beschichtet werden sollen, deren Siegelflächengeometrie ein höheres Maß an Ungenauigkeit aufweisen, wie dies beispielsweise bei tiefgezogenen Verpackungsbehältern der Fall ist, da durch den Tiefziehvorgang am inneren Randbereich der Siegelfläche im Regelfall Material abgezogen wird, sodass beispielsweise eine in etwa trichterförmig konturierte Siegelfläche resultiert - um hier einen ausreichenden Schutz der Siegelfläche zu gewährleisten, d. h. das Spaltmaß bzw. den Abstand zwischen der Siegelfläche und dem Träger zu minimieren, ist es bevorzugt die Kraftbeaufschlagung durch die Niederhaltemittel so zu wählen, dass die Verpackungsbehälter während des Beschichtungsvorgangs mithilfe der Niederhaltemittel elastisch und/oder plastisch deformiert werden, um eine Angleichung der Siegelfläche an die Trägerfläche bzw. Kontaktfläche des Trägers zu bewirken, wodurch ein Beschichtungsplasma und/oder Gaseintritt, zumindest in einer solchen Menge, dass es zu einer vollflächigen Beschichtung kommt, sicher vermieden wird. Zusätzlich oder alternativ zu dem Vorsehen von Niederhaltemitteln kann die Kontur der Kontaktfläche des Trägers, bevorzugt durch eine konische und/oder zur horizontal abgeschrägten Ausführung an die Kontur der Siegelfläche, bevorzugt formkongruent, angepasst werden, um den Abstand zwischen Kontakt- und Siegelfläche zu minimieren.

Im Hinblick auf die konkrete Ausgestaltung der Niederhaltemittel gibt es, wie erwähnt (aktiv vs. passiv) unterschiedliche Möglichkeiten, auch im Hinblick auf die Niederhaltemittelgeometrie. Besonderes bevorzugt ist es, wenn die Niederhaltemittel mit einem Ringabschnitt, d. h. mit einem umfangsgeschlossenen Abschnitt auf den jeweiligen Verpackungsbehälter aufliegen bzw. sich an diesen abstützen. Unabhängig von der Kontaktflächengeometrie der Niederhaltemittel ist es bevorzugt, wenn die von den Niederhaltemittel verdeckte Verpackungsbehälterfläche und somit die Größe der Kontaktfläche der Niederhaltemittel zu den Verpackungsbehältern kleiner ist, insbesondere um mindestens 50 % kleiner als die Siegelfläche der Verpackungsbehälter, die durch Auflage auf dem Träger vor einer Barriereschichtbeschichtung geschützt wird.

Im Rahmen des Verfahrens ist in Weiterbildung der Erfindung vorgesehen, dass die Kavitäten der Verpackungsbehälter nach dem Beschichtungsvorgang mit der Barriereschicht mit Packgut, insbesondere Kosmetika, Lebensmittel oder Arzneimittel befüllt werden, woraufhin dann die Kavitäten mittels einer Folie durch thermisches Siegeln der Folie an die Siegelfläche des jeweiligen Verpackungsbehälters verschlossen werden. Die Beschichtung kann inline mit dem Befüllen und dem Siegelprozess erfolgen, was bevorzugt ist - alternativ können die beschichteten Verpackungsbehälter zwischengelagert und/oder zu einer Abfüll- und Siegelstation transportiert werden.

Die Erfindung führt auch auf eine Verwendung einer Vorrichtung, die bestimmt und ausgebildet ist zur Durchführung des erfindungsgemäßen Verfahrens. Die Handhabungsmittel sind, insbesondere durch Programmierung einer entsprechenden Steuerung derart ausgebildet, dass diese die Verpackungsbehälter, beispielsweise mechanisch durch Klemmen und/oder durch Vakuumbeaufschlagung greifen und derart auf den Träger aufsetzen bzw. absetzen, dass die Verpackungsbehälter während der Beschichtung mit ihrer Siegelfläche dem Träger zur Maskierung gegen eine Beschichtung mit der Vakuum-Barriereschicht zugewandt sind.

Weitere Vorteile, Merkmal und Einzelheiten der Erfindung ergeben sich aus der nachfolgenden Beschreibung, den bevorzugten Ausführungsbeispiele sowie anhand der Zeichnungen.

Diese zeigen in:
- Fig. 1: in einer Draufsicht einen flächigen Träger mit darauf aufgesetzten, zu beschichtenden Kunststoff-Verpackungsbehältern,
- Fig. 2: eine Schnittansicht der Anordnung gem. Fig. 1 entlang der Schnittlinie A-A, und
- Fig. 3: ein vergrößertes Detail aus Fig. 2 aus dem ersichtlich ist, dass die Verpackungsbehälter mit der (späteren) Siegelfläche dem Träger zugewandt sind bzw. sich an diesem abstützen.

In den Figuren sind gleiche Elemente und Elemente mit der gleichen Funktion mit den gleichen Bezugszeichen gekennzeichnet.

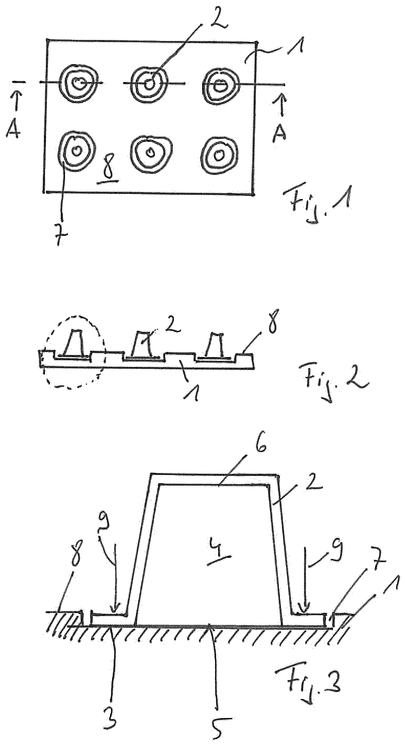

In den Fig. 1 bis 3 ist ein Träger (englisch: carrier) mit dem Bezugszeichen 1 gekennzeichnet. Dieser dient zur Aufnahme einer Vielzahl von Verpackungsbehältern 2 aus Kunststoff während eines an sich bekannten Vakuum-Beschichtungsvorgangs. Aus Übersichtlichkeitsgründen sind in dem Ausführungsbeispiel lediglich sechs Verpackungsbehälter 2 dargestellt - tatsächlich kann ein Träger 1 je nach Größe der Verpackungsbehälter 2 und der nicht gezeigten Vakuum-Beschichtungskammer eine deutlich höhere Anzahl von Verpackungsbehältern 2 tragen. Während der Vakuum-Beschichtung werden üblicherweise mehrere jeweils horizontal ausgerichtete Träger 1, jeweils tragend einer Mehrzahl von Verpackungsbehältern 2 übereinander angeordnet, um gleichzeitig in eine möglichst große Anzahl von Verpackungsbehältern 2 mit einer jeweiligen Vakuum-Barriereschicht, insbesondere einer SiOₓ-Schicht, insbesondere im CVD- oder ALD-Verfahren zu beschichten.

Wie sich insbesondere aus einer Zusammenschau der Fig. 2 und 3 ergibt, stehen die Verpackungsbehälter 2, hier in Form von Bechern quasi kopfüber auf dem Träger 1, jedenfalls derart, dass eine umfangsgeschlossene Siegelfläche 3 zum späteren Festlegen einer (Deckel-)Folie durch thermisches Siegeln vor einer Beschichtung mit der Vakuum-Barriereschicht mittels des Trägers geschützt ist. In dem konkreten Ausführungsbeispiel stehen die Verpackungsbehälter 2 unmittelbar mit ihrer Siegelfläche 3 auf dem Träger 1 auf, sodass der Träger 1 die Siegelfläche 3 während des Vakuumbeschichtungsvorgangs maskiert, d. h. vor einer Beschichtung mit der Barriereschicht schützt.

Insbesondere aus Fig. 3 ist ein allgemeiner Aufbau eines Verpackungsbehälters 2 ersichtlich, wobei die Geometrie selbstverständlich grundsätzlich von der konkret gezeigten Ausführungsform abweichen kann. Wesentlich ist, dass der Verpackungsbehälter 2 aus Kunststoff eine Kavität 4 zur späteren Aufnahme von Packgut aufweist sowie die vorerwähnte Siegelfläche, die eine Kavitätenöffnung 5 vollumfänglich umfangsgeschlossen umgibt. Auf der Unterseite weist jede Kavität einen Kavitätenboden 6 auf, mit dem der Verpackungsbehälter 2 im befüllten Zustand üblicherweise auf einer Unterlage aufsteht - aus der Anordnung gemäß den Fig. 1 bis 3 ist zu erkennen, dass die Verpackungsbehälter 2 bezogen auf diese "normale Standweise" umgekehrt bzw. um 180° verdreht auf dem Träger 1 aufsitzen um die Siegelfläche zu maskieren.

Aus den Figuren ist weiter ersichtlich, dass die Verpackungsbehälter 2 in jeweils einer Zentriervertiefung 7 angeordnet sind, also in jeweils einer Vertiefung auf einer Oberseite 8 (bezogen auf eine Vertikale) angeordnet sind. Die Abmessungen des Vertiefungsquerschnitts sind so bemessen, dass ein Verpackungsbehälter 2 unter Berücksichtung üblicher Fertigungstoleranzen unter Einhaltung eines seitlichen Spiels automatisiert eingesetzt werden kann. Die Zentriervertiefungen 7 stabilisieren bzw. positionieren den Verpackungsbehälter 2 auf dem Träger 1, insbesondere während des Ein- und Ausladens eines Trägers in eine nicht gezeigte, an sich bekannte Vakuum-Beschichtungskammer.

In Fig. 3 sind mit Pfeilen 9 außerhalb der Erfindung liegende Niederhaltemittel angedeutet, mit denen die Verpackungsbehälter 2 bei Bedarf mit ihrer Siegelfläche 3 gegen den Träger 1 kraftbeaufschlagt werden können, insbesondere unter gleichzeitiger Deformation des Verpackungsbehälters 2, was insbesondere bei tiefgezogenen Verpackungsbehältern 2 aus Kunststoff vorteilhaft ist, um somit zu einer Abstandsminimierung zum Träger 1 beizutragen.

Nach einem derartigen Beladen des Trägers 1 mit den Verpackungsbehältern 2, sodass diese mit ihrer Siegelfläche 3 in Richtung Träger 1 weisen, wird eine Vakuumbeschichtungskammer mit dem horizontal ausgerichteten Träger, vorzugsweise mit mehreren übereinander angeordneten Trägern befüllt und es erfolgt der Beschichtungsvorgang mit der Barriereschicht im Vakuum. Danach wird der mindestens eine Träger wieder aus der Beschichtungskammer entnommen und die Verpackungsbehälter 2 werden von dem Träger 1 abgenommen, um dann in einem späteren Verfahrensschritt durch Aufnahme von Packgut in der jeweiligen Kavität befüllt und danach mit einer Folie verschlossen zu werden, die hiezu jeweils thermisch an die jeweilige barriereschichtfreie Siegelfläche 3 gesiegelt wird.

### Bezugszeichenliste

- 1: Träger
- 2: Verpackungsbehälter
- 3: Siegelfläche
- 4: Kavität
- 5: Kavitätenöffnungen
- 6: Kavitätenboden
- 7: Zentriervertiefung
- 8: Oberseite des Trägers
- 9: Pfeile (Niederhaltemittel)

## Patentansprüche

1. Verfahren zum Beschichten von Verpackungsbehältern (2) aus Kunststoff, jeweils umfassend mindestens eine Kavität (4) zur Aufnahme eines Packgutes, sowie mindestens eine Siegelfläche (3) zum späteren Verschließen der Kavität (4) mit einer Folie durch Siegeln der Folie an der Siegelfläche (3) des Verpackungsbehälters (2) mit einer Barriereschicht im Vakuum zum Erhöhen der Durchtrittssperrwirkung gegen mindestens eine chemische Verbindung und/oder mindestens ein chemisches Element, wobei mehrere Verpackungsbehältnisse auf einen Träger (1) aufgesetzt und die auf dem Träger (1) befindlichen Verpackungsbehältnisse gemeinsam in einer Vakuumbeschichtungskammer mit der Barriereschicht beschichtet werden, wobei die Verpackungsbehälter (2) derart auf den Träger (1) aufgesetzt werden, dass die Verpackungsbehälter (2) während der Beschichtung mit Ihrer Siegelfläche (3) dem Träger (1) zur Maskierung gegen eine Beschichtung mit der Barriereschicht zugewandt sind
**dadurch gekennzeichnet,**
**dass** die Verpackungsbehälter (2) während der Beschichtung ausschließlich aufgrund ihres Eigengewichtes auf dem Träger (1) aufsitzen und jeweils in einer Zentriervertiefung auf dem Träger aufstehen, wobei die Querschnitssfläche der Zentriervertiefung geringfügig größer als die axiale Projektionsfläche des Verpackungsbehälters ist, sodass dieser kopfüber auf dem Träger aufgesetzt werden kann und bei der Handhabung des Trägers seitlich durch eine Vertiefungsumfangswand gehalten wird

2. Verfahren nach Anspruch 1,
**dadurch gekennzeichnet,**
**dass** die Verpackungsbehälter (2) mit ihrer Siegelfläche (3) auf dem Träger (1) aufliegen und/oder ein Abstand zwischen der Siegelfläche (3) und dem Träger (1) so gering ist, dass die Siegelfläche (3) beim Beschichten des Verpackungsbehälters (2) frei von der Barriereschicht bleibt.

3. Verfahren nach einem der vorhergehenden Ansprüche,
**dadurch gekennzeichnet,**
**dass** die Verpackungsbehälter (2) automatisiert nach dem Beschichten von dem Träger (1), insbesondere unter Wenden, entnommen werden.

4. Verfahren nach einem der vorhergehenden Ansprüche,
**dadurch gekennzeichnet,**
**dass** die Kavitäten (4) nach dem Beschichten mit Packgut befüllt und danach jeweils mittels einer Folie durch thermisches Siegeln der Folie an die Siegelfläche (3) des verschlossen werden.

5. Verwendung einer Vorrichtung zur Durchführung eines Beschichtungsverfahrens nach einem der vorhergehenden Ansprüche, umfassend eine Vakuumbeschichtungskammer zum Beschichten der Verpackungsbehälter (2) mit der Barriereschicht im Vakuum sowie Handhabungsmittel zum Aufsetzen jeweils mehrerer Verpackungsbehälter auf Träger (1), wobei die Handhabungsmittel derart ausgebildet sind dass diese die Verpackungsbehälter (2) derart auf den Träger (1) aufsetzen, dass die Verpackungsbehälter (2) während der Beschichtung mit Ihrer Siegelfläche (3) dem Träger (1) zur Maskierung gegen eine Beschichtung mit der Barriereschicht zugewandt sind
**dadurch gekennzeichnet,**
**dass** die Verpackungsbehälter (2) während der Beschichtung ausschließlich aufgrund ihres Eigengewichtes auf dem Träger (1) aufsitzen und jeweils in einer Zentriervertiefung auf dem Träger aufstehen, wobei die Querschnittsfläche der Zentriervertiefung geringfügig größer als die axiale Projektionsfläche des Verpackungsbehälters ist, sodass dieser kopfüber auf dem Träger aufgesetzt werden kann und bei der Handhabung des Trägers seitlich durch die Vertiefungsumfangswand gehalten wird.

## Claims

1. A method for coating packaging containers (2) made of plastic, each packaging container (2) comprising at least one cavity (4) for receiving a packaged good and at least one seal surface (3) for subsequently closing the cavity (4) by means of a film by sealing the film to the seal surface (3) of the packaging container (2) with a barrier layer in vacuum for increasing the passage barrier effect against at least one chemical compound and/or at least one chemical element, several packaging containers being placed on a carrier (1) and the packaging containers located on the carrier (1) being jointly coated with the barrier layer in a vacuum coating chamber, the packaging containers (2) being placed on the carrier (1) in such a manner that, during the coating, the seal surface (3) of the packaging containers (2) faces the carrier (1) so as to be masked from being coated with the barrier layer,
**characterized in that**
during the coating, the packaging containers (2) rest on the carrier (1) solely as a result of their own weight and each stand on the carrier in a centering recess, the cross-sectional area of the centering recess being slightly larger than the axial projection area of the packaging container, said packaging container thus being placeable upside down on the carrier and being held laterally by a circumferential recess wall during the handling of the carrier.

2. The method according to claim 1,
**characterized in that**
the seal surface (3) of the packaging containers (2) rests on the carrier (1) and/or that a distance between the seal surface (3) and the carrier (1) is so small that the seal surface (3) remains free of the barrier layer when the packaging container (2) is coated.

3. The method according to any one of the preceding claims,
**characterized in that**
the packaging containers (2) are automatically removed from the carrier (1) after the coating, the packaging containers (2) in particular being turned in the process.

4. The method according to any one of the preceding claims,
**characterized in that**
the cavities (4) are filled with packaged goods after the coating and are then each closed by means of a film by thermal sealing of the film to the seal surface (3).

5. A use of a device for performing a coating method according to any one of the preceding claims, the device comprising a vacuum coating chamber for coating the packaging containers (2) with the barrier layer in vacuum and handling means for placing several packaging containers on carriers (1) at the same time, the handling means being realized in such a manner that they place the packaging containers (2) on the carrier (1) in such a manner that, during the coating, the seal surface (3) of the packaging containers (2) faces the carrier (1) so as to be masked from being coated with the barrier layer,
**characterized in that**
during the coating, the packaging containers (2) rest on the carrier (1) solely as a result of their own weight and each stand on the carrier in a centering recess, the cross-sectional area of the centering recess being slightly larger than the axial projection area of the packaging container, said packaging container thus being placeable upside down on the carrier and being held laterally by the circumferential recess wall during the handling of the carrier.

## Revendications

1. Procédé de revêtement des récipients d'emballage (2) en plastique, chaque récipient d'emballage (2) comprenant au moins une cavité (4) pour recevoir un produit à emballer et au moins une surface de scellage (3) pour la fermeture ultérieure de la cavité (4) au moyen d'un film en scellant le film à la surface de scellage (3) du récipient d'emballage (2) avec une couche de barrière sous vide afin d'augmenter l'effet de barrière de passage contre au moins un composé chimique et/ou au moins un élément chimique, plusieurs récipients d'emballage étant placés sur un support (1) et les récipients d'emballage situés sur le support (1) étant revêtus ensemble de la couche de barrière dans une chambre de revêtement sous vide, les récipients d'emballage (2) étant placés sur le support (1) de telle manière que, pendant le revêtement, la surface de scellage (3) des récipients d'emballage (2) est tournée vers le support (1) afin d'être masquée contre un revêtement de la couche de barrière,
**caractérisé en ce que**
pendant le revêtement, les récipients d'emballage (2) reposent sur le support (1) exclusivement en raison de leur poids propre et se trouvent chacun dans un renfoncement de centrage sur le support, la surface de section transversale du renfoncement de centrage étant légèrement plus grande que la surface de projection axiale du récipient d'emballage, ledit récipient d'emballage pouvant donc être placé à l'envers sur le support et étant retenu latéralement par une paroi circonférentielle de renfoncement pendant la manipulation du support.

2. Procédé selon la revendication 1,
**caractérisé en ce que**
la surface de scellage (3) des récipients d'emballage (2) repose sur le support (1) et/ou qu'une distance entre la surface de scellage (3) et le support (1) est si petite que la surface de scellage (3) reste exempte de la couche de barrière pendant le revêtement du récipient d'emballage (2).

3. Procédé selon l'une quelconque des revendications précédentes,
**caractérisé en ce que**
les récipients d'emballage (2) sont automatiquement retirés du support (1) après le revêtement, notamment tout en étant tourné.

4. Procédé selon l'une quelconque des revendications précédentes,
**caractérisé en ce**
**qu'**après le revêtement, les cavités sont remplies de produits à emballer et sont ensuite fermées chacune au moyen d'un film par scellage thermique du film à la surface de scellage (3).

5. Utilisation d'un dispositif pour effectuer un procédé de revêtement selon l'une quelconque des revendications précédentes, le dispositif comprenant une chambre de revêtement sous vide servant à revêtir les récipients d'emballage (2) de la couche de barrière sous vide et des moyens de manipulation servant à placer plusieurs récipients d'emballage sur des supports (1) à chaque fois, les moyens de manipulation étant réalisés de telle manière qu'ils placent les récipients d'emballage (2) sur le support (1) de telle manière que, pendant le revêtement, la surface de scellage (3) des récipients d'emballage (2) est tournée vers le support (1) afin d'être masquée contre un revêtement de la couche de barrière,
**caractérisé en ce que**
pendant le revêtement, les récipients d'emballage (2) reposent sur le support (1) exclusivement en raison de leur poids propre et se trouvent chacun dans un renfoncement de centrage sur le support, la surface de section transversale du renfoncement de centrage étant légèrement plus grande que la surface de projection axiale du récipient d'emballage, ledit récipient d'emballage pouvant donc être placé à l'envers sur le support et étant retenu latéralement par la paroi circonférentielle de renfoncement pendant la manipulation du support.
